# EUROPÄISCHE PATENTANMELDUNG

(11) **EP 3 130 812 A1**
(43) Veröffentlichungstag der Anmeldung: **15.02.2017**
(21) Anmeldenummer: 15181079.3
(22) Anmeldetag: 14.08.2015
(51) Int. Cl.: F16C 17/02, F16C 33/10

(54) **MEHRSEGMENTGLEITLAGER UND VERFAHREN ZUM PROFILIEREN DES MEHRSEGMENTGLEITLAGERS**

(71) Anmelder: Siemens Aktiengesellschaft, 80333 München (DE)
(72) Erfinder: Ehehalt, Ulrich, 45239 Essen (DE); Grein, Roland Georg, 45468 Mülheim an der Ruhr (DE); Jäger, Philippe, 45549 Spockhövel (DE); Mermertas, Ümit, 45478 Mülheim an der Ruhr (DE)

(57) **Zusammenfassung**

Die Erfindung betrifft ein Mehrsegmentleitlager zum Lagern eines Rotors (2) mit einer Mehrzahl an Segmenten (6, 7), die eine radial nach innen gewandte Gleitfläche (10, 11) aufweisen, wobei mindestens eine der Gleitflächen in einem Querschnitt senkrecht zur Rotorachse (5) ein nichtkreisförmiges Profil hat.

## Beschreibung

Die Erfindung betrifft ein Mehrsegmentgleitlager und ein Verfahren zum Profilieren des Mehrsegmentgleitlagers.

Eine Turbomaschine, wie beispielsweise eine Gasturbine oder ein Dampfturbine, oder ein Generator weist ein oder mehrere Gleitlager auf, auf dem ein Rotor der Turbomaschine gelagert ist. Das Gleitlager soll eine möglichst reibungsfreie Drehung des Rotors im Betrieb der Turbomaschine ermöglichen. Zudem trägt das Gleitlager die statische Last des Rotors. Darüber hinaus beeinflusst das Gleitlager das dynamische Laufverhalten des Rotors. Beispielsweise beeinflusst das Gleitlager die Schwingungen des Rotors, insbesondere die Biegeschwingung. Die Schwingungen sind nachteilig, weil sie die Lebensdauer der Turbomaschine, des Generators und der Lager verkürzen.

Um die Schwingungen des Rotors zu minimieren, die Dämpfung zu erhöhen oder eine rotordynamische Stabilität zu erzeugen, wird häufig ein Kippsegmentgleitlager eingesetzt, um den Rotor zu lagern. Das Kippsegmentgleitlager weist eine Mehrzahl an Segmenten mit jeweils einer Gleitfläche auf, auf denen der Rotor im Betrieb der Turbomaschine gleiten kann. Die Segmente sind leicht beweglich, wodurch sie im Betrieb der Turbomaschine oder des Generators der Lage des Rotors folgen, was häufig zu einer Reduzierung der Schwingungsamplituden im Vergleich zum Einsatz eines Festsegmentlagers führt. Nachteilig ist jedoch, dass Kippsegmentgleitlager nur eine begrenzte Gewichtskraft tragen können und zudem kostenintensiv sind.

Aufgabe der Erfindung ist es, ein Gleitlager und ein Verfahren zum Profilieren des Gleitlagers zu schaffen, wobei das Gleitlager eine lange Lebensdauer des von dem Gleitlager gelagerten Rotors und des Gleitlagers selbst ermöglicht.

Das erfindungsgemäße Mehrsegmentleitlager zum Lagern eines Rotors weist eine Mehrzahl an Segmenten auf, die eine radial nach innen gewandte Gleitfläche aufweisen, wobei mindestens eine der Gleitflächen in einem Querschnitt senkrecht zur Rotorachse ein nichtkreisförmiges Profil hat. Mit dem erfindungsgemäßen Mehrsegmentgleitlager lassen sich Biegeschwingungen des Rotors mit geringeren Amplituden erzielen als es mit herkömmlichen kreisförmigen Profilen möglich ist. Dadurch haben der von dem Mehrsegmentgleitlager gelagerte Rotor und das Mehrsegmentgleitlager sowie andere von Schwingungen beeinflusste Bauteile, wie beispielsweise Dichtungen, vorteilhaft eine lange Lebensdauer.

Es ist bevorzugt, dass das Mehrsegmentgleitlager ein Festsegmentgleitlager ist. Durch das nichtkreisförmige Profil lassen sich für das Festsegmentgleitlager ähnlich geringe Amplituden der Biegeschwingungen wie für ein Kippsegmentgleitlager erzielen. Dadurch, dass das Festsegmentgleitlager keine beweglichen Segmente aufweist, ist es vorteilhaft kostengünstiger als das Kippsegmentgleitlager und kann zudem eine größere Gewichtskraft als das Kippsegmentgleitlager tragen.

Die erfindungsgemäße Turbomaschine weist das Mehrsegmentgleitlager und den Rotor auf, wobei das Mehrsegmentgleitlager den Rotor lagert.

Das erfindungsgemäße Verfahren zum Profilieren eines Mehrsegmentgleitlagers, das eingerichtet ist einen Rotor zu lagern und eine Mehrzahl an Segmenten aufweist, die eine radial nach innen gewandte Gleitfläche aufweisen, weist die Schritte auf: a) Festlegen einer Ausgangsgeometrie für die Gleitflächen, wobei die Gleitflächen in einem Querschnitt senkrecht zur Rotorachse ein Profil haben; b) Rechnerisches Bestimmen von mindestens einer Biegeschwingungsmode des auf dem Mehrsegmentlager gelagerten Rotors; c) Variieren der Ausgangsgeometrie von mindestens einer der Gleitflächen derart, dass das Profil nichtkreisförmig wird; d) Rechnerisches Bestimmen der Biegeschwingungsmode des auf dem Mehrsegmentlager mit der variierten Geometrie gelagerten Rotors. Das rechnerische Bestimmen kann beispielsweise mit einer Finiten Elemente Methode erfolgen. Die derart profilierten Mehrsegmentgleitlager ermöglichen Biegeschwingungen des Rotors mit geringeren Amplituden als es mit herkömmlichen kreisförmigen Profilen möglich ist. Dadurch haben der von dem Mehrsegmentgleitlager gelagerte Rotor und das Mehrsegmentgleitlager sowie andere von Schwingungen beeinflusste Bauteile, wie beispielsweise Dichtungen, vorteilhaft eine lange Lebensdauer. Des Weiteren können Rotoren länger und schlanker gebaut werden ohne die rotordynamische Stabilität zu gefährden.

Es ist bevorzugt, dass in Schritt c) das Profil derart variiert wird, dass ein horizontaler Versatz eines Gleitflächenmittelpunktes zur Rotorachse, ein vertikaler Versatz des Gleitflächenmittelpunktes zur Rotorachse und/oder ein Gleitflächenradius, der der Abstand von dem Gleitflächenmittelpunkt zu der Gleitfläche ist, in Umfangsrichtung variiert. Dies stellt ein besonders einfaches Verfahren dar, um das nichtkreisförmige Profil zu erstellen. Der horizontale Versatz in Abhängigkeit der Umfangsrichtung, der vertikale Versatz in Abhängigkeit der Umfangsrichtung und/oder der Gleitflächenradius in Abhängigkeit der Umfangsrichtung ist bevorzugt ein Spline, ein Ellipsensegment, eine trigonometrische Funktion, insbesondere eine Sinusfunktion, und/oder ein Polynom.

Es ist bevorzugt, dass das Verfahren den Schritt aufweist: e) Akzeptieren der variierten Geometrie für den Fall, dass die Dämpfung der Biegeschwingungsmode der variierten Geometrie stärker als für die Ausgangsgeometrie ist, anderenfalls Durchführen der Schritte c) und d) mit einer anderen variierten Geometrie. Die Dämpfung kann ebenfalls mit der Finiten Elemente Methode berechnet werden. Durch den Verfahrensschritt e) wird vorteilhaft das Profil derart optimiert, dass das Mehrsegmentgleitlager die Biegeschwingung des Rotors stark dämpft, so dass die Schwingungen des Rotors vermindert werden und dessen Lebensdauer sowie die Lebensdauer des Mehrsegmentgleitlagers verlängert wird.

Bevorzugt weist das Verfahren den Schritt auf: e) Akzeptieren der variierten Geometrie für den Fall, dass die Eigenfrequenz der Biegeschwingungsmode der variierten Geometrie gegenüber der Eigenfrequenz der Biegeschwingungsmode für die Ausgangsgeometrie derart verschoben ist, dass die Biegeschwingungsmode der variierten Geometrie weniger dazu neigt, beim Rotieren des Rotors angeregt zu werden, anderenfalls Durchführen der Schritte c) und d) mit einer anderen variierten Geometrie. Die Eigenfrequenz kann ebenfalls mit der Finiten Elemente Methode berechnet werden. Durch diesen Verfahrensschritt e) wird vorteilhaft das Profil derart optimiert, dass die Lebensdauer des Rotors verlängert wird. In Schritt e) wird die variierte Geometrie bevorzugt akzeptiert, wenn die Eigenfrequenz von der Drehfrequenz des Rotors weg verschoben wird.

Bevorzugt weist das Verfahren den Schritt auf: e) Akzeptieren der variierten Geometrie für den Fall, dass die Dämpfung einer relevanten Eigenfrequenz der Biegeschwingungsmode der variierten Geometrie gegenüber der Dämpfung der relevanten Eigenfrequenz der Biegeschwingungsmode für die Ausgangsgeometrie derart verschoben ist, dass sich die Dämpfung der Biegeschwingungsmode vergrößert und positiv ist, anderenfalls Durchführen der Schritte c) und d) mit einer anderen variierten Geometrie. Die Dämpfung der Eigenfrequenz kann ebenfalls mit der Finiten Elemente Methode berechnet werden. In der Regel wird die Dämpfung der Eigenfrequenz in einem Berechnungsschritt mit der Berechnung der Eigenfrequenz durchgeführt. Durch diesen Verfahrensschritt e) wird vorteilhaft das Profil derart optimiert, dass eine kostengünstige und/oder wirkungsgradgünstige Bauweise der Turbomaschine realisiert wird. In Schritt e) wird bevorzugt die variierte Geometrie bevorzugt akzeptiert, wenn die Dämpfung der Eigenfrequenz ein Maximum einnimmt.

Es ist bevorzugt, dass mit der akzeptieren Geometrie als Ausgangsgeometrie die Verfahrensschritte a), c) und d) wiederholt werden. Dadurch ist ein iterativer Prozess geschaffen, mit dem die Schwingungen des Rotors vorteilhaft minimiert werden können.

Das Mehrsegmentgleitlager ist bevorzugt ein Festsegmentgleitlager. Es ist bevorzugt, dass das Verfahren für ein weiteres Mehrsegmentgleitlager durchgeführt wird, das den Rotor lagert.

Im Folgenden wird anhand der beigefügten schematischen Zeichnung die Erfindung näher erläutert. Es zeigen:
- Figur 1: ein Zweikeillager,
- Figur 2: ein Dreikeillager,
- Figur 3: ein Offset-Halves Lager,
- Figur 4: ein Offset-Halves Lager mit nichtkreisförmigen Profilen und
- Figur 5: ein Dreikeillager mit nichtkreisförmigen Profilen.

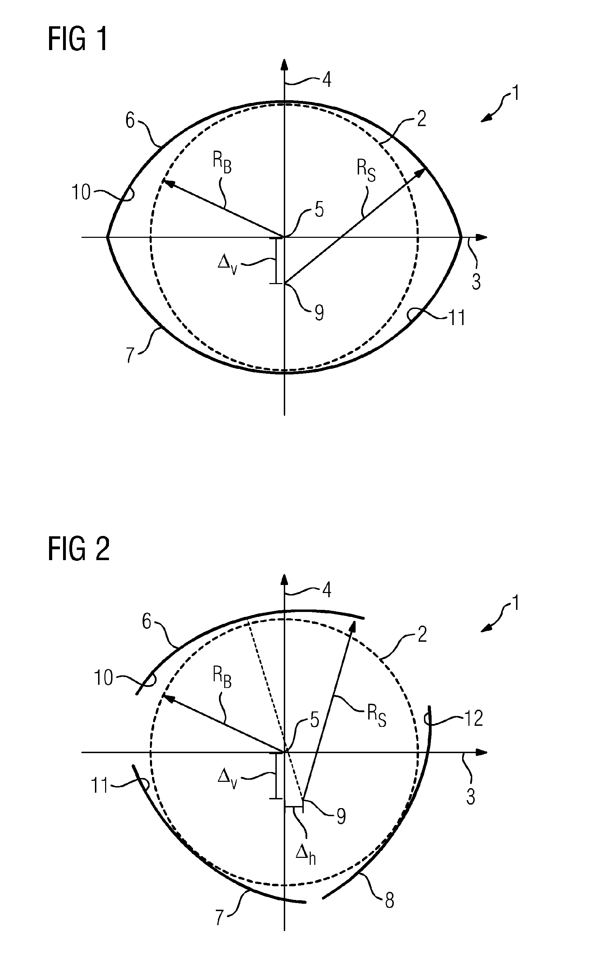

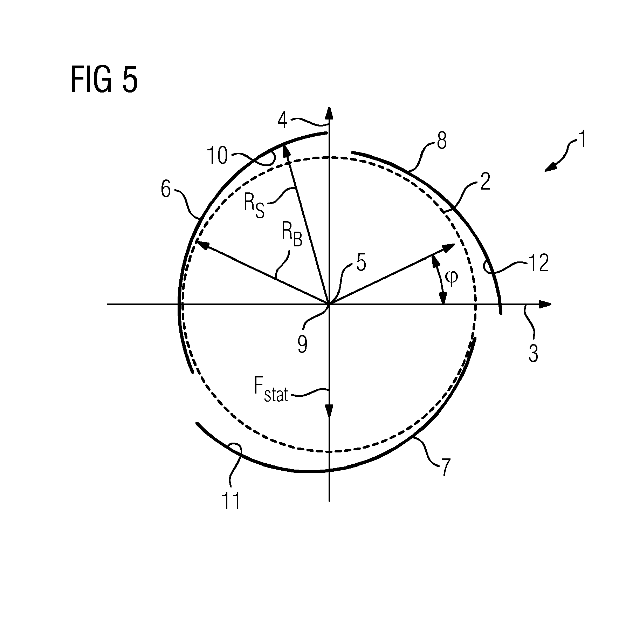

Figuren 1 bis 5 zeigen jeweils einen Querschnitt eines Mehrsegmentgleitlagers 1 mit einem auf dem Mehrsegmentgleitlager 1 gelagerten Rotors 2. Das Mehrsegmentgleitlager 1 und der Rotor 2 können Teil einer Turbomaschine sein, beispielsweise einer Gasturbine oder einer Dampfturbine. Jedes der Mehrsegmentgleitlager 1 weist eine Mehrzahl an Segmenten 6 bis 8 auf, wobei das Mehrsegmentgleitlager 1 gemäß Figuren 1, 3 und 4 zwei Segmente 6, 7 und das Mehrsegmentgleitlager 1 gemäß Figuren 2 und 5 drei Segmente 6 bis 8 aufweist. Es ist denkbar, dass die Anzahl der Segmente mehr als drei beträgt.

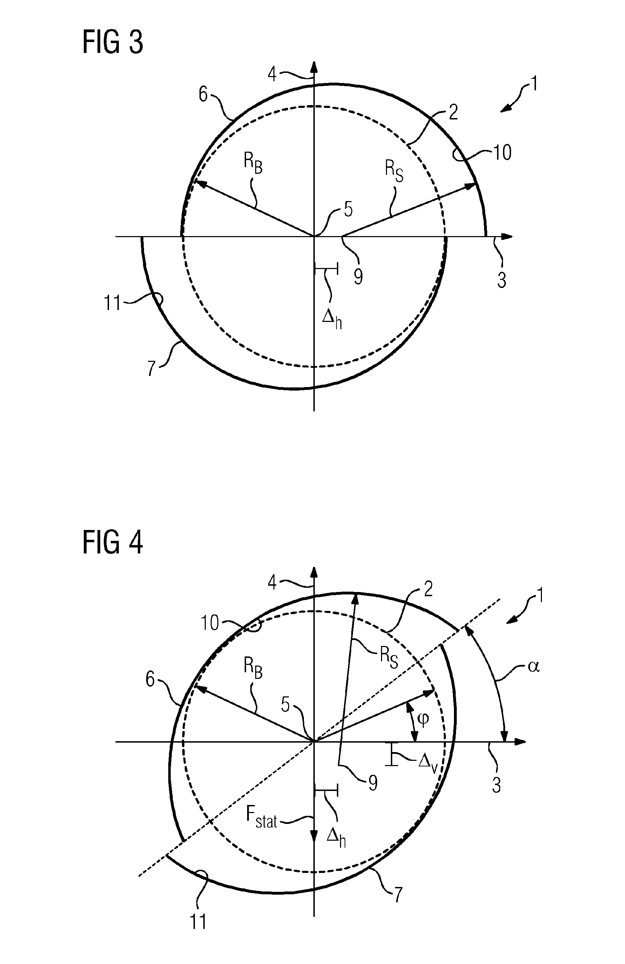

Wie es aus Figuren 1 bis 5 ersichtlich ist, weist der Rotor 2 einen Rotorradius R_{B} und eine Rotorachse 5 auf, um die der Rotor 2 sich in seinem Betrieb dreht. Die Rotorachse 5 ist senkrecht zu dem Querschnitt angeordnet. Ebenfalls ist in Figuren 1 bis 5 ein Koordinatensystem mit einer horizontalen Achse 3 und einer vertikale Achse 4 eingezeichnet. Der Ursprung des Koordinatensystems fällt mit der Rotorachse 5 zusammen. Das Koordinatensystem steht fest und dreht nicht mit dem Rotor mit. Figuren 4 und 5 zeigen zusätzlich die auf das Mehrsegmentlager 1 wirkende Gewichtskraft Fₛₜₐₜ des Rotors 2. Gemäß Figuren 1 bis 5 weist jedes der Segmente 6 bis 8 eine radial nach innen gewandte Gleitfläche 10 bis 12 auf, an der im Betrieb des Rotors 2 dieser gleitet. Die Gleitflächen 10 bis 12 haben in einem Querschnitt senkrecht zur Rotorachse 5 ein Profil. Dieses Profil wird dargestellt durch einen horizontalen Versatz Δₕ eines Gleitflächenmittelpunktes 9 zur Rotorachse 5, einen vertikalen Versatz Δᵥ des Gleitflächenmittelpunktes 9 zur Rotorachse 5 und einem Gleitflächenradius R_{S}, der der Abstand von dem Gleitflächenmittelpunkt 9 zu der Gleitfläche 10 bis 12 ist.

Figuren 4 und 5 zeigen den Fall, dass die Profile nichtkreisförmig sind. Dies wird dadurch erreicht, dass der horizontale Versatz Δₕ, der vertikale Versatz Δᵥ und/oder der Gleitflächenradius R_{S} in Umfangsrichtung variieren. In anderen Worten ist mindestens eine der Funktionen Δₕ(ϕ), Δᵥ(ϕ), R_{S}(ϕ) nicht konstant, wobei der Winkel zu der horizontalen Achse 3 in Umfangsrichtung ist. Die Funktionen Δₕ(ϕ), Δᵥ(ϕ), R_{S}(ϕ) können ein Spline, ein Ellipsensegment, eine trigonometrische Funktion, insbesondere eine Sinusfunktion und/oder eine Kosinusfunktion, und/oder ein Polynom sein. Auch weitere Funktionen sind denkbar. Denkbar ist, dass mehrere Profile eines Mehrsegmentgleitlagers 1 die gleiche Form haben. Ebenso sind Profile mit unterschiedlichen Formen in einem Mehrsegmentgleitlager 1 denkbar, bei denen mindestens ein Profil nichtkreisförmig ist.

Das Mehrsegmentgleitlager 1 gemäß Figur 4 ist ein Offset-Halve Gleitlager, bei dem die zu dem ersten Segment 6 gehörige erste Gleitfläche 10 das gleiche Profil hat wie die zu dem zweiten Segment 7 gehörige zweite Gleitfläche 11. Die beiden Segmente 6 und 7 sind in einer Ebene gegeneinander verschoben, die einen Segmentwinkel α mit der horizontalen Achse 3 einschließt.

Das Mehrsegmentgleitlager 1 gemäß Figur 5 ist ein Dreikeillager, bei dem die zu dem ersten Segment 6 gehörige erste Gleitfläche 10, die zu dem zweiten Segment 7 gehörige zweite Gleitfläche 11 und die zu dem dritten Segment 8 gehörige dritte Gleitfläche 12 jeweils einen Winkel von <120° in Umfangsrichtung überstreichen.

Das Mehrsegmentgleitlager 1 gemäß Figur 1 ist ein Zweikeillager, bei dem die zu dem ersten Segment 6 gehörige erste Gleitfläche 10 und die zu dem zweiten Segment 7 gehörige zweite Gleitfläche 11 einen Winkel von <180° in Umfangsrichtung überstreichen, wobei die beiden Segmente 6 und 7 spiegelsymmetrisch bezüglich der horizontalen Achse 3 zueinander angeordnet. Die Profile der Gleitflächen 10, 11 sind kreisförmig. Das Mehrsegmentgleitlager 1 gemäß Figur 1 kann erfindungsgemäß abgeändert werden, indem mindestens eins der Profile der beiden Segmente 6 und 7 nichtkreisförmig ausgeführt wird.

Das Mehrsegmentgleitlager 1 gemäß Figur 2 ist ein Dreikeillager, bei dem die zu dem ersten Segment 6 gehörige erste Gleitfläche 10, die zu dem zweiten Segment 7 gehörige zweite Gleitfläche 11 und die zu dem dritten Segment 8 gehörige dritte Gleitfläche 12 jeweils einen Winkel von <120° in Umfangsrichtung überstreichen. Die Profile der Gleitflächen 10 bis 12 sind kreisförmig. Das Mehrsegmentgleitlager 1 gemäß Figur 2 kann erfindungsgemäß abgeändert werden, indem mindestens eins der Profile der Segmente 6 bis 8 nichtkreisförmig ausgeführt wird.

Das Mehrsegmentgleitlager 1 gemäß Figur 3 ist ebenfalls ein Offset-Halve Lager wie das Mehrsegmentgleitlager 1 gemäß Figur 4, wobei bei dem Mehrsegmentgleitlager 1 gemäß Figur 3 der Segmentwinkel α Null ist und die Profile der zu dem ersten Segment 6 gehörigen ersten Gleitfläche 10 und der zu dem zweiten Segment 7 gehörigen zweiten Gleitfläche 11 kreisförmig sind. Das Mehrsegmentgleitlager 1 gemäß Figur 3 kann erfindungsgemäß abgeändert werden, indem mindestens eins der Profile der beiden Segmente 6 und 7 nichtkreisförmig ausgeführt wird.

Ein beispielhaftes Verfahren zum Profilieren des Mehrsegmentgleitlagers 1 weist die Schritte auf: a) Festlegen einer Ausgangsgeometrie für die Profile; b) Rechnerisches Bestimmen von mindestens einer Biegeschwingungsmode des auf dem Mehrsegmentlager 1 gelagerten Rotors 2; c) Variieren der Ausgangsgeometrie von mindestens einer der Gleitflächen 10 bis 12 derart, dass das Profil nichtkreisförmig wird, derart, dass der horizontale Versatz Δₕ des Gleitflächenmittelpunktes 9 zur Rotorachse 5, der vertikale Versatz Δᵥ des Gleitflächenmittelpunktes 9 zur Rotorachse 5 und/oder der Gleitflächenradius R_{S} in Umfangsrichtung variiert; d) Rechnerisches Bestimmen der Biegeschwingungsmode des auf dem Mehrsegmentlager 1 mit der variierten Geometrie gelagerten Rotors 2; e) Akzeptieren der variierten Geometrie für den Fall, dass die Dämpfung der Biegeschwingungsmode der variierten Geometrie stärker als für die Ausgangsgeometrie ist, anderenfalls Durchführen der Schritte c) und d) mit einer anderen variierten Geometrie; f) Wiederholen mit der akzeptieren Geometrie als Ausgangsgeometrie die Verfahrensschritte a), c) und d). Das Verfahren kann anschließend für ein weiteres Mehrsegmentgleitlager durchgeführt werden, das den Rotor 2 lagert. Das rechnerische Bestimmen der Biegeschwingungsmode und dessen Dämpfung kann mit einer Finiten Elemente Methode erfolgen.

Obwohl die Erfindung im Detail durch die bevorzugten Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Mehrsegmentleitlager zum Lagern eines Rotors (2) mit einer Mehrzahl an Segmenten (6 bis 8), die eine radial nach innen gewandte Gleitfläche (10 bis 12) aufweisen,
wobei mindestens eine der Gleitflächen (10 bis 12) in einem Querschnitt senkrecht zur Rotorachse (5) ein nichtkreisförmiges Profil hat.

2. Mehrsegmentgleitlager gemäß Anspruch 1,
wobei das Mehrsegmentgleitlager (1) ein Festsegmentgleitlager ist.

3. Turbomaschine mit einem Mehrsegmentgleitlager (1) und dem Rotor (2) gemäß Anspruch 1 oder 2,
wobei das Mehrsegmentgleitlager (1) den Rotor (2) lagert.

4. Verfahren zum Profilieren eines Mehrsegmentgleitlagers (1), das eingerichtet ist einen Rotor (2) zu lagern und eine Mehrzahl an Segmenten (6 bis 8) aufweist, die eine radial nach innen gewandte Gleitfläche (10 bis 12) aufweisen, mit den Schritten:
a) Festlegen einer Ausgangsgeometrie für die Gleitflächen (10 bis 12), wobei die Gleitflächen (10 bis 12) in einem Querschnitt senkrecht zur Rotorachse (5) ein Profil haben;
b) Rechnerisches Bestimmen von mindestens einer Biegeschwingungsmode des auf dem Mehrsegmentlager (1) gelagerten Rotors (2);
c) Variieren der Ausgangsgeometrie von mindestens einer der Gleitflächen (10 bis 12) derart, dass das Profil nichtkreisförmig wird;
d) Rechnerisches Bestimmen der Biegeschwingungsmode des auf dem Mehrsegmentlager (1) mit der variierten Geometrie gelagerten Rotors (2).

5. Verfahren gemäß Anspruch 4,
wobei in Schritt c) das Profil derart variiert wird, dass ein horizontaler Versatz (Δₕ) eines Gleitflächenmittelpunktes (9) zur Rotorachse (5), ein vertikaler Versatz (Δᵥ) des Gleitflächenmittelpunktes (9) zur Rotorachse (5) und/oder ein Gleitflächenradius (R_{S}), der der Abstand von dem Gleitflächenmittelpunkt (9) zu der Gleitfläche (10 bis 12) ist, in Umfangsrichtung variiert.

6. Verfahren gemäß Anspruch 5,
wobei der horizontale Versatz (Δₕ) in Abhängigkeit der Umfangsrichtung, der vertikale Versatz (Δᵥ) in Abhängigkeit der Umfangsrichtung und/oder der Gleitflächenradius (R_{S}) in Abhängigkeit der Umfangsrichtung ein Spline, ein Ellipsensegment, eine trigonometrische Funktion, insbesondere eine Sinusfunktion, und/oder ein Polynom ist.

7. Verfahren gemäß einem der Ansprüche 4 bis 6,
mit dem Schritt:
e) Akzeptieren der variierten Geometrie für den Fall, dass die Dämpfung der Biegeschwingungsmode der variierten Geometrie stärker als für die Ausgangsgeometrie ist, anderenfalls Durchführen der Schritte c) und d) mit einer anderen variierten Geometrie.

8. Verfahren gemäß einem der Ansprüche 4 bis 6,
mit dem Schritt:
e) Akzeptieren der variierten Geometrie für den Fall, dass die Eigenfrequenz der Biegeschwingungsmode der variierten Geometrie gegenüber der Eigenfrequenz der Biegeschwingungsmode für die Ausgangsgeometrie derart verschoben ist, dass die Biegeschwingungsmode der variierten Geometrie weniger dazu neigt beim Rotieren des Rotors (2) angeregt zu werden, anderenfalls Durchführen der Schritte c) und d) mit einer anderen variierten Geometrie.

9. Verfahren gemäß Anspruch 8,
wobei in Schritt e) die variierte Geometrie akzeptiert wird, wenn die Eigenfrequenz von der Drehfrequenz des Rotors (2) weg verschoben wird.

10. Verfahren gemäß einem der Ansprüche 4 bis 6,
mit dem Schritt:
e) Akzeptieren der variierten Geometrie für den Fall, dass die Dämpfung einer relevanten Eigenfrequenz der Biegeschwingungsmode der variierten Geometrie gegenüber der Dämpfung der relevanten Eigenfrequenz der Biegeschwingungsmode für die Ausgangsgeometrie derart verschoben ist, dass sich die Dämpfung der Biegeschwingungsmode vergrößert und positiv ist, anderenfalls Durchführen der Schritte c) und
d) mit einer anderen variierten Geometrie.

11. Verfahren gemäß Anspruch 10,
wobei in Schritt e) die variierte Geometrie bevorzugt akzeptiert wird, wenn die Dämpfung der Eigenfrequenz ein Maximum einnimmt.

12. Verfahren gemäß einem der Ansprüche 7 bis 11,
mit dem Schritt:
f) Wiederholen mit der akzeptieren Geometrie als Ausgangsgeometrie die Verfahrensschritte a), c) und d).

13. Verfahren gemäß einem der Ansprüche 4 bis 12,
wobei das Mehrsegmentgleitlager (1) ein Festsegmentgleitlager ist.

14. Verfahren gemäß einem der Ansprüche 4 bis 13,
wobei das Verfahren für ein weiteres Mehrsegmentgleitlager durchgeführt wird, das den Rotor (2) lagert.
